# EUROPÄISCHE PATENTANMELDUNG

(11) **EP 2 378 575 A1**
(43) Veröffentlichungstag der Anmeldung: **19.10.2011**
(21) Anmeldenummer: 10160341.3
(22) Anmeldetag: 19.04.2010
(51) Int. Cl.: H01L 33/50, H01L 33/58, C09K 11/77, F21V 9/16, H05B 33/20

(54) **Optisches Element, insbesondere zur Veränderung des von einer LED- Lichtquelle emittierten Lichts, und Verfahren zu dessen Herstellung**

(71) Anmelder: EMPA Eidgenössische Materialprüfungs- und Forschungsanstalt, 8600 Dübendorf (CH)
(72) Erfinder: Koebel, Matthias, 8306 Brüttisellen (CH)
(74) Vertreter: Kleinschmidt, Michael

(57) **Zusammenfassung**

Ein optisches Element, insbesondere zur Veränderung des von einer LED-Lichtquelle (L) emittierten Lichts, umfasst einen Lichtdiffusor (D) sowie einen Farbkonverter (F). Der Lichtdiffusor (D) ist zu mindestens 60% Volumenanteil aus einem Aerogelmaterial mit einer Porosität von mindestens 85% gebildet, und der Farbkonverter (F; F1; F2) ist aus mindestens einem Lumineszenzmittel gebildet, wobei das Aerogelmaterial mit dem Lumineszenzmittel durchsetzt und/oder von diesem im Wesentlichen vollständig umschlossen ist. Das Aerogelmaterial des optischen Diffusors wird durch einen Sol-Gel-Prozess hergestellt.

## Beschreibung

### Technisches Gebiet

Die Erfindung betrifft ein optisches Element gemäss Oberbegriff des Anspruchs 1 sowie ein Verfahren zu dessen Herstellung.

### Stand der Technik

Lichtbeeinflussende Systeme wie etwa optische Diffusoren, farbverschiebende Materialien und dünne Schichten, Prismen, Lichtleiter etc. sind bereits in grosser Vielfalt in der Licht- und Beleuchtungsindustrie bekannt und finden daher auch in alltäglichen Gerätschaften (Lampen, Leuchten, Akzentbeleuchtungen, optische Systeme, Studio- und Theaterbeleuchtung, Multimedia usw.) eine Vielzahl von Anwendungen.

Die konventionelle Beleuchtungstechnik befindet sich heute im Umbruch von Glühlampen und UV-angeregten Leuchtstoffröhren hin zu Halbleiter-basierten Systemen. Solche "Light Emitting Diode" (LED) Beleuchtungen weisen eine rasante Entwicklung im Bezug auf deren Lichtausbeute auf und werden schon in naher Zukunft die energieeffizientesten Lichtquellen darstellen. Die besten kommerziell erhältlichen weissen LEDs erreichten Ende 2009 eine Lichtausbeute von >100 Lumen/W. Diese Werte sind mit der Energieeffizienz von Fluoreszenzlampen und CFL (so genannte "compact fluorescent lamps") vergleichbar. Damit steht fest, dass LEDs die traditionellen Technologien mittel- bis langfristig ersetzen werden.

Das Hauptproblem was die Anwendung von LEDs in der Beleuchtungstechnik betrifft, ist die punktförmige Art solcher Lichtquellen sowie die damit verbundenen enormen Licht-Dichten oder -Flüsse (Lumen/cm²) und die dadurch bedingte Blendproblematik. Um eine gleichmässige Ausleuchtung eines Raums bzw. einer Fläche zu erreichen, bedarf es einer gleichmässigen Verteilung des Lichts. Zwar sind heute LEDs mit enormer Lichtleistung (so genannte high-power LED mit 1W, 3W, 5W, 10W etc.) erhältlich. Dennoch wirken diese als Punktstrahler und damit sehr grell für den Betrachter. Aus diesem Grund werden solche LEDs hauptsächlich als Akzentlicht, in der Strassenbeleuchtung sowie im Automobilbereich eingesetzt, haben aber in der Innenraumbeleuchtung noch nicht wirklich Einzug gehalten.

Um die Problematik der hohen Lichtdichte zu reduzieren, bedient man sich daher eines Diffusorkörpers, welcher einen beträchtlichen Anteil des Lichts in diffuser Art und Weise gleichmässig in alle Richtungen an den Raum abgibt. Die US 7,111,961 B2 beschreibt eine derartige Konstruktion, welche eine einer konventionellen Glühbirne vergleichbare Lichtleistung durch eine Kombination mehrerer LEDs erreicht und das Licht über einen Diffusor an die Umgebung abgibt.

Konventionelle Diffusormaterialien wie etwa Milchglas / Mattglasscheiben oder Kunststoffklebefolien oder allgemein polymere Materialien mit oder ohne Zuschlag von Partikeln wie etwa Silicagel oder ähnliche weisen typischerweise Lichtverluste im Bereich von 10 bis 40% auf. Diese vergleichsweise hohen Verluste widerspiegeln sich direkt in der Energiebilanz von darauf abgeleiteten Beleuchtungssystemen.

Als eine ungewöhnliche Klasse von Diffusormaterialien sind Aerogele zu erwähnen.

In der DE 10 2006 056 394 A1 ist ein Beleuchtungssystem beschrieben, welches durch ein von einer Lichtquelle hinterleuchtetes, lichtdurchlässiges Bauteil gekennzeichnet ist, welches unter anderem aus Aerogel in irgendeiner Form ausgeprägt sein kann. Daraus resultiere eine Beleuchtungseinrichtung, welche zur gleichzeitigen Schall- und Lichtwiedergabe genutzt werden kann. In der besagten Offenlegungsschrift ist das Aerogelmaterial allerdings nicht weiter beschrieben. In der erwähnten Ausführung dient das lichtdurchlässige Bauteil ebenfalls als Medium zur Schalltransmission bzw. -wiedergabe. Somit müssen in einer derartigen Konfiguration die akustischen Eigenschaften des Materials, insbesondere des verwendeten Aerogelmaterials, auf Kosten der optischen Eigenschaften angepasst werden.

Als weiterer Schwachpunkt von Leuchtdioden in der Beleuchtungsindustrie ist das Emissionsspektrum von weissen LEDs zu erwähnen, welches eine unbefriedigende Farbwiedergabe zur Folge hat. Weisse Hochleistungs-LEDs bestehen aus einer blauen LED (Emission bei λ ~ 460-490nm) mit entsprechender Flächenleistung, auf welche eine dünne farbverschiebende Schicht aus einem Lumineszenzmittel, oftmals auch "Phosphor" genannt, der oft auch als Garnet (zu deutsch "Granat" oder Halbedelstein) oder Luminophor bezeichnet wird. Eine synthetische Garnet-Schicht absorbiert einen Teil des generierten blauen Lichts und reemittiert sichtbares Licht in Form eines breiten Kontinuums über weite Teile des sichtbaren Bereichs bei höheren Wellenlängen (rotverschoben) und zwar im Wellenlängenbereich 500nm > λ > 650nm. Durch Mischung von transmittiertem, blauem Primärlicht und der farbverschobenen Sekundärkomponente aus dem Garnet entsteht weisses Licht. Das Hauptproblem bei dieser Technologie liegt in der geringen Anzahl an einsetzbaren Garnet-Verbindungen, welche für die Farbverschiebung von blauem Licht überhaupt geeignet sind. Zudem sind die verwendeten Phosphorschichten, da direkt im Halbleitergehäuse integriert, einem enormen Lichtfluss und thermischen Belastungen ausgesetzt, was wiederum bedeutet, dass sie auch gegen Alterungsprozesse beständig sein müssen. Dies bedeutet eine weitere Verringerung der Auswahl an geeigneten Phosphoren. Somit wird der Wunsch, das ausgestrahlte optische Spektrum einer solchen weissen LED anpassen zu können und damit ein möglichst natürliches, tageslichtähnliches Licht zu generieren, stark eingeschränkt.

In der Produktionstechnologie für weisse, Phosphor-basierte LEDs unterscheidet man kaltweisse und warmweisse LEDs mit Farbtemperaturen von ca. 6500 K bzw. 3500K. Erstere wirken wie der Name schon sagt kalt, da sie einen hohen Anteil des blauen Primärlichts enthalten. Letztere wirken wärmer, haben jedoch einen vergleichsweise zu geringen Blauanteil. Phosphor-basierte LEDs sind zwar bezüglich Lichtausbeute und Herstellungskosten überaus attraktiv, können aber aufgrund ihrer Nachteiligen spektralen Eigenschaften mit anderen Leuchtmitteln wie etwa Halogen-Glühbirnen nicht mithalten: Aufgrund ihrer minderwertigen Farbwiedergabeeigenschaften haben sie daher noch wenig Einzug in den Innenbeleuchtungsmarkt gehalten.

Diverse Verfahren und Methoden zur Verbesserung der Diffusions- und spektralen Eigenschaften von Phosphor-basierten, weissen LEDs im Halbleiterelement selbst sind bekannt.

Die US 2008/0074032 A1 beschreibt ein Herstellungsverfahren für eine weisse LED durch Farbverschiebung ausgehend von einer kurzwelligen (blau oder UV) LED mittels eines Phospors. In demselben Gehäuse ist zudem ein Diffusormaterial, bestehend aus lichtstreuenden Partikeln, in die Verpackung mit integriert, was die Abstrahleigenschaften verbessern und das Blenden verringern soll.

Die WO 2008/125672 A1 beschreibt eine LED basierte Lichtquelle, welche neben einer weissen, Phosphor-basierten LED noch weitere zuschaltbare LED-Elemente enthält, welche das ausgesendete Licht durch zusätzliche direkte Quellen (beispielsweise Zuschalten einer "gelben" LED) bzw. indirekte Quellen (Zuschalten einer UV-LED, was den Phosphor zusätzlich stimuliert und die daraus resultierende Emission verstärkt, ohne aber den Blauanteil anzuheben) nach Wunsch verändern lassen.

Prinzipiell kann die Farbverschiebung auch ausserhalb in Form eines Films oder optischen Elements erreicht werden.

Die WO 2006/034561 A1 beschreibt ein optisches Farbverschiebungselement in der Form eines Xerogelmaterials, welches so genannte "Quantum Dots" als farbverschiebende Phoshpore fein dispergiert im Trägermaterial enthält. Als bevorzugte Materialien zur Herstellung von Quantum-Dots sind Typ III-V, II-VI und I-VII Halbleiterpaarkombinationen bekannt. Xerogele wirken jedoch in dicken Schichten zu stark lichtstreuend, um in der Beleuchtungstechnik wirkungsvoll eingesetzt werden zu können.

### Darstellung der Erfindung

Aufgabe der Erfindung ist es, ein verbessertes gattungsgemässes optisches Element bereit zu stellen, mit welchem sich insbesondere die eingangs erwähnten Nachteile von heute bekannten LED-Beleuchtungselementen im Bezug auf Blendverhalten und Lichtfarbe bzw. Farbwiedergabe vermeiden lassen.

Die Aufgabe wird erfindungsgemäss gelöst durch ein optisches Element gemäss Anspruch 1 sowie durch ein Herstellungsverfahren gemäss Anspruch 15.

Das erfindungsgemässe optische Element, welches insbesondere zur Veränderung des von einer LED-Lichtquelle emittierten Lichts vorgesehen ist, umfasst einen Lichtdiffusor sowie einen Farbkonverter. Erfindungsgemäss ist der Lichtdiffusor zu mindestens 60% Volumenanteil aus einem Aerogelmaterial mit einer Porosität von mindestens 85% gebildet und der Farbkonverter aus mindestens einem Lumineszenzmittel gebildet, wobei das Aerogelmaterial mit dem Lumineszenzmittel durchsetzt und/oder von diesem im Wesentlichen vollständig umschlossen ist. Wie aus dem Folgenden näher hervorgeht, ist der Begriff "im Wesentlichen umschlossen" so zu verstehen, dass das Lumineszenzmittel (bzw. der Farbkonverter) sich derart um das Aerogelmaterial (bzw. den Lichtdiffusor) herum erstreckt, dass ein überwiegender Anteil des von einer zugeordneten Lichtquelle (insbesondere einer oder mehrerer LED-Lichtquellen) her einfallenden Lichtes zunächst durch das Lumineszenzmittel (bzw. der Farbkonverter) hindurch auf das Aerogelmaterial (bzw. den Lichtdiffusor) trifft und anschliessend wieder durch das Lumineszenzmittel (bzw. der Farbkonverter) an die Umgebung austritt. Dies umfasst auch solche Anordnungen, bei welchen der Farbkonverter beispielsweise als Mantelfläche eines zylindrischen Behälters ausgebildet ist, jedoch nicht die Deckel- und Bodenfläche mit einschliesst, falls diese aus Funktionalitätsgründen beispielsweise aus einem nicht-transparenten Material gebildet sind.

Dabei haben die Massnahmen der Erfindung zunächst einmal zur Folge, dass der Diffusor eine sehr hohe Transmission im sichtbaren Bereich des optischen Spektrums von 480nm bis 750nm aufweist, was Lichtverluste minimiert und energieeffiziente Beleuchtungssysteme in bis daher unbekannter Weise realisieren lässt. Der als farbverschiebende Komponente wirkende Farbkonverter ist aus einem an sich bekannten Lumineszenzmittel, beispielsweise ein Phosphor, "Garnet" oder Luminophor gebildet. Bei Anregung durch Primärlicht im Spektralbereich zwischen 350nm und 500nm emittiert das Lumineszenzmittel ein gegenüber dem Primärlicht rotverschobenes Sekundärlicht mit einer vergleichsweise breiten Spektralverteilung. Dementsprechend lässt sich insbesondere bei Anregung mit LEDs eine veränderte, in der Regel angenehmere Lichtfarbe erzielen.

Es versteht sich, dass das erfindungsgemässe optische Element sowohl für direkte als auch für indirekte Beleuchtungseinrichtungen geeignet ist.

Weiterhin kann das erfindungsgemässe optische Element nicht nur mit LED-Komponenten, sondern auch mit anderen geeigneten Lichtquellen eingesetzt werden. Insbesondere ist das erfindungsgemässe optische Element auch für Sonnenlicht, das gegebenenfalls fokussiert werden kann, einsetzbar.

Das Aerogelmaterial selbst hat typischerweise eine Dichte im Bereich von 3% bis 15% der chemischen Komponente bzw. Komponenten im festen Aggregatszustand aus welchem es aufgebaut ist. In einer typischen Anwendung wird ein SiO₂ Aerogel mit einer Dichte ρ = 0.14 g cm⁻³ sowie einer Porosität von 92% als Aerogelmaterial eingesetzt.

Gemäss einem weiteren Aspekt der Erfindung wird bei der Herstellung eines erfindungsgemässen optischen Elementes das Aerogelmaterial des optischen Diffusors durch einen Sol-Gel-Prozess hergestellt.

Vorteilhafte Ausführungsformen sind in den abhängigen Ansprüchen definiert.

Zur Verwendung als optischer Diffusor sind prinzipiell mehrere Ausgestaltungen des Aerogeldiffusors denkbar.

In einer ersten Ausführungsform liegt das Aerogel als Ganulat mit einer mittleren Partikelgrösse im Bereich von 1.0mm +/- 0.3mm bis 10.0 +/- 0.3mm vor und wird als Schüttgut in einen hohlen Körper aus einem transparenten Material wie etwa Glas, Plexiglas, Polycarbonat oder ähnlich eingefüllt. Ebenfalls denkbar ist das befüllen von losen, mehr oder weniger frei verformbaren transparenten Behältnissen oder Objekten, welche einem Sack, einer Tüte oder einem Ballon ähnlich sind. Das resultierende Paneel bzw. der Körper stellt dann das eigentliche Diffusorelement dar. Dieses soll eine Gesamtlichttransparenz >85% aufweisen. Ebenfalls möglich ist die Zusammensetzung eines Schüttguts aus mehreren Granulatfraktionen von jeweils unterschiedlicher Partikelgrösse. Das Aerogelgranulat liegt vorteilhafterweise in einem lichtdurchlässigen Behältnis vor, das mit dem Lumineszenzmittel belegt oder von diesem durchsetzt ist.

In einer weiteren Ausführungsform ist der Aerogeldiffusor als monolithischer Körper ausgebildet, wobei zumindest eine Mantelfläche des Lichtdiffusors mit dem Lumineszenzmittel belegt ist. Beispielsweise kann ein solcher monolithischer Aerogeldiffusor als Platte, Kugel, Quader oder diverse andere geometrische Formen oder Superpositionen derselben ausgestaltet sein. Ebenfalls denkbar sind komplexe Formen und Figuren aus monolithischem Aerogel wie etwa Skulpturen, Statuetten oder ähnliche Körper.

Weiterhin kann der monolithische Aerogeldiffusor mit dem Lumineszenzmittel durchsetzt sein. Optional kann zumindest eine Mantelfläche des Lichtdiffusors mit einem weiteren Lumineszenzmittel belegt sein.

Für die Art, Ausprägung sowie Integration des Farbkonverters sind erfindungsgemäss zwei Ausprägungsarten vorgesehen.

In einer ersten Ausführungsart ist das den Farbkonverter bildende Lumineszenzmittel direkt im Aerogelmaterial integriert, welches somit vom Lumineszenzmittel durchsetzt ist, oder das Lumineszenzmittel ist auf dem Areogelmaterial abgeschieden. Bei beiden dieser Untervarianten sind die lichtstreuenden und lumineszierenden Eigenschaften in einem einzigen Aerogelmaterial vereint. Hierzu sind zwei grundlegend verschiedene Techniken möglich. Einerseits können Phosphors in irgendeiner Form (z.B. als molekularer Farbstoff, als Pigment, Mikro- oder Nanopartikel oder in einer Faser- bzw. einer Kunststoffmatrix, etc.) bereits während der Herstellung des Aerogelmaterials dispergiert zum Sol bzw. zur Lösung zugegeben werden. Andererseits können Aerogelmaterialien oder Granulate auch durch Beschichtungsverfahren nachträglich mit Phosphors versetzt werden, z.B. in einem Sprühverfahren, wobei das Lösemittel verdampft und eine Phosphorschicht auf der Oberfläche bzw. teils im Material zurückbleibt.

In einer weiteren Ausführungsart wird das Lumineszenzmittel in eine nicht-Aerogel-Phase eingearbeitet, welche das Aerogelmaterial im Wesentlichen vollständig umschliesst. Hierzu kann als Farbkonverter eine dünne Folie oder ein Film, ein transparenter Feststoff, ein Glas oder ein transparenter Kunststoff wie etwa Polycarbonat, Polyester, Acrylglas, eine Silikonverbindung oder aber eine Kombination derartiger Materialien verwendet werden, welche zumindest ein Lumineszenzmittel enthält bzw. enthalten.

Bei einer weiteren vorteilhaften Ausgestaltung ist der Lichtdiffusor mit mindestens einem Lichtleiter zum Einspeisen von Licht ausgestattet.

In einer Ausführungsform ist das Lumineszenzmittel mindestens eine Verbindung der Klasse der organischen Phosphore, der Quantum Dots, der Familien der III-V, II-VI und I-VII Halbleiterpaare oder der Granate (garnets) oder es enthält ein lumineszierendes Polymer.

In einer weiteren Ausführungsform enthält das Aerogelmaterial als Hauptkomponente eine aus Siliziumoxid, Titanoxid, Aluminiumoxid, Zirkonoxid, Eisenoxid, Chromoxid, Vanadiumoxid, Ceroxid und Nioboxid ausgewählte Verbindung.

Vorteilhafterweise weist das Aerogelmaterial eine Dichte auf, die ungefähr 1 % bis ungefähr 20% der gemittelten Dichte seiner Bestandteile beträgt.

In einer weiteren Ausgestaltung umfasst der Farbkonverter zusätzlich zum Lumineszenzmittel ein Aerogel oder ein mesoporöses Metalloxid oder ein Xerogel als volumenmässige Hauptkomponente.

Weiterhin kann der Farbkonverter zusätzlich zum Lumineszenzmittel ein anorganisches oxidisches Material, ein Glas oder ein Polymer als volumenmässige Hauptkomponente umfassen.

### Kurze Beschreibung der Zeichnungen

Ausführungsbeispiele der Erfindung werden nachfolgend anhand der Zeichnungen näher beschrieben, dabei zeigen:
- Fig. 1: ein optisches Element mit vier LED-Lichtquellen, in einer schematischen Querschnittdarstellung;
- Fig. 2: eine erste Ausführungsform des optischen Elements, im Querschnitt;

- Fig. 3: eine zweite Ausführungsform des optischen Elements, im Querschnitt;
- Fig. 4: eine dritte Ausführungsform des optischen Elements, im Querschnitt;
- Fig. 5: ein optisches Element mit einer LED- Lichtquelle und einer fiberoptischen Einkopplung des Anregungslichts, in einer schematischen Querschnittdarstellung;
- Fig. 6 bis 8: drei beispielhafte Ausgestaltungen eines monolithischen optischen Elements mit zugehörigen LED- Lichtquellen; und
- Fig. 9 bis 12: vier beispielhafte Ausgestaltungen eines aus Aerogel-Granulat gebildeten optischen Elements mit zugehörigen LED- Lichtquellen.

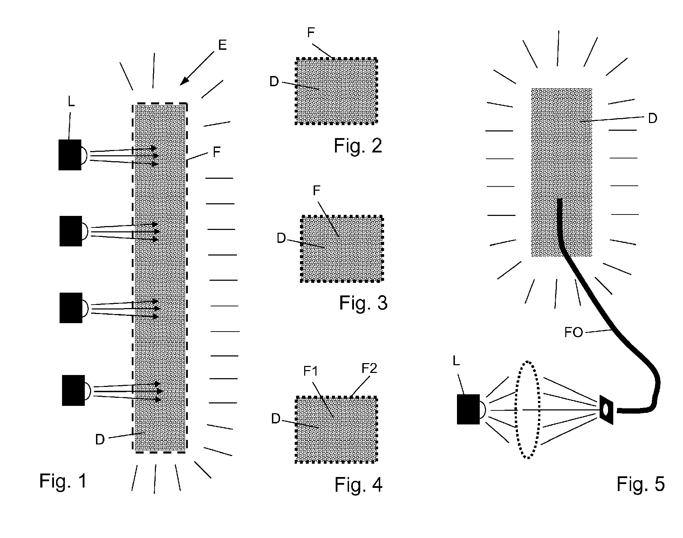

Die Figur 1 zeigt schematisch ein quaderförmig ausgestaltetes optisches Element E mit vier zugeordneten LED-Lichtquellen L. Dabei ist das optische Element E durch einen als Diffusor D wirkenden monolithischen Aerogelkörper gebildet, der an seiner Oberfläche mit einem als Farbkonverter F wirkenden Lumineszenzmittel belegt ist. Wie aus der Figur 1 hervorgeht, wirkt der Aerogelkörper als Diffusor D für die vergleichsweise gebündelte Strahlung der LED-Lichtquellen. Das Lumineszenzmittel, welches in diesem Beispiel den Aerogelkörper A im wesentlichen vollständig umschliesst, wirkt als Farbkonverter F für das eingestrahlte und nach Streuung am Aerogeldiffusor wieder aus dem optischen Element austrendede Licht.

Die Figuren 2 bis 4 zeigen verschiedene prinzipielle Ausführungsformen des optischen Elements, welches jeweils einen Diffusor und mindestens einen Farbkonverter umfasst. Der Diffusor kann dabei als monolithischer Aerogelkörper oder als Aerogelgranulat in einem geeigneten Behältnis ausgestaltet sein.

Das optische Element der Figur 2 umfasst einen Diffusor D, welcher von einem Farbkonverter F im wesentlichen vollständig umschlossen ist.

Das optische Element der Figur 3 umfasst einen Diffusor D, welcher vom Farbkonverter F durchsetzt ist.

Das optische Element der Figur 4 umfasst einen Diffusor D, welcher von einem ersten Farbkonverter F1 durchsetzt und von einem zweiten Farbkonverter F2 im wesentlichen vollständig umschlossen ist.

Die Figur 5 zeigt eine weitere Art der direkten optischen Anregung bzw. Ausleuchtung mittels eines in einen monolithischen Aerogelkörper A eingegossenen Lichtleiterkabels FO (Fiberoptik). Bei Bedarf kann die Lichteinkopplung zusätzlich durch einen transparenten massiven Körper, beispielsweise aus Glas, erfolgen, welcher ebenfalls in den Aerogelkörper A eingegossen und in welchen das Lichtleiterkapel einegossen ist. Es versteht sich, dass zur Einkopplung des von der LED-Lichtquelle L erzeugten Anregungslichts in das Lichtleiterkabel eine an sich bekannte Optik verwendet wird.

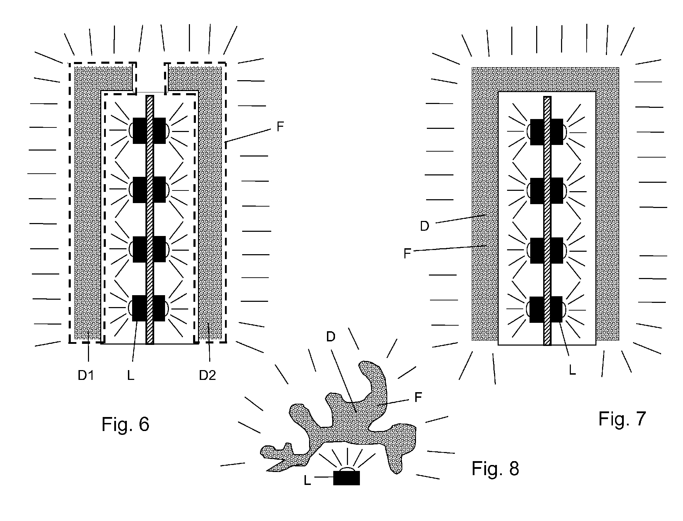

Die in der Figur 6 dargestellte Ausführungsform umfasst zwei L-förmige Aerogeldiffusoren D1 und D2, welche zusammen ein U-förmiges optisches Element bilden, das eine Gruppe von 2 mal 4 LED- Lichtquellen L umschliesst. In diesem Beispiel ist jeder Diffusor mit einem Lumineszenzmittel F beschichtet.

Die in der Figur 7 dargestellte Ausführungsform umfasst einen U-förmigen Aerogeldiffusor D, welcher eine Gruppe von 2 mal 4 LED- Lichtquellen L umschliesst. In diesem Beispiel ist der Diffusor mit einem Lumineszenzmittel F durchsetzt. Die in der Figur 8 dargestellte Ausführungsform umfasst einen als komplexes unregelmässiges Gebilde ausgestalteten Aerogeldiffusor D, der mit einem Lumineszenzmittel F beschichtet ist. In diesem Beispiel erfolgt die Anregung mit einer einzelnen LED- Lichtquelle L.

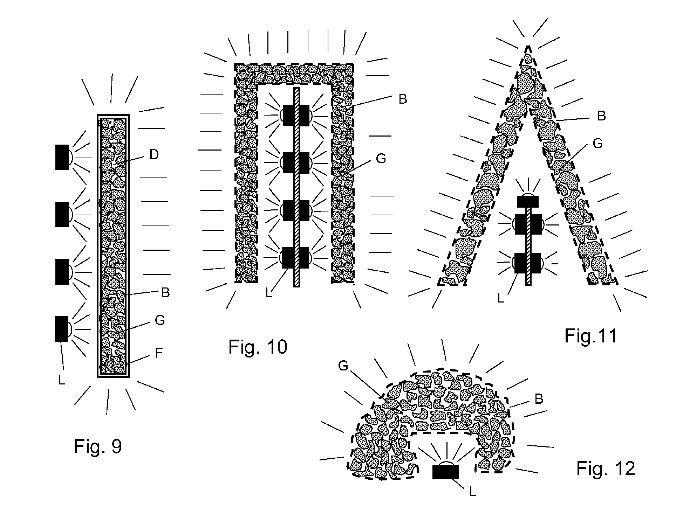

In den Figuren 9 bis 12 sind weitere Ausführungsformen gezeigt, bei denen der Diffusor D jeweils durch ein Aerogelgranulat G gebildet ist, das sich in einem entsprechend geformten transparenten Behältnis B befindet. Je nach Anwendungsbereich befindet sich das zur Farbkonversion erforderliche Lumineszenzmittel F in oder auf der Wandschicht des Behältnisses B (vgl. Figur 9) und/oder im Aerogelgranulat G oder als Beimischung in Form einer vorzugsweise transparenten, lumineszierenden Zweitphase (in den Figuren 10 bis 12 nicht dargestellt).

Es versteht sich, dass zur Veränderung des Lichtspektrums (Farbtemperatur) des vom optischen Element abgestrahlten Lichts eine oder mehrere aktive Sekundärlichtquellen zur zusätzlichen bzw. selektiven Stimulierung des / der Lumineszenzmittel(s) zugeschaltet werden können.

### Wege zur Ausführung der Erfindung

### Auswahl von typischen Pigmenten sowie Farbverschiebungskomponenten und deren technische Merkmale

**Tabelle 1: Pigmente und Phosphore, welche zur Farbverschiebung eingesetzt werden können sowie eine Auswahl von optischen und Struktur-Eigenschaften in exemplarischer Form:**

| **Aktive Phosphorkomponente, Dotierungselement** | **Substanzklasse:** | **Morphologie** | **Anregung** | **Emission** |
|---|---|---|---|---|
| Perylenphosphor Grün | Organisch | Molekül | 420-480nm | 480-550nm |
| Perylenphosphor Orange | Organisch | Molekül | 480-540nm | 530-580nm |
| Perylenphosphor Rot | Organisch | Molekül | 510-590nm | 590-670nm |
| Polyanthrachinon | Organisch/Hybrid | Polymer | 240-400nm | 500-800nm |
| Coumarin 6 | Organisch | Molekül | 400-490nm | 470-600nm |
| (ZnS:Cu,Al). | Halbleiter | Mikrokristallin | 280-350nm | 500-550nm |
| SiO2/Zn2SiO4:V | Spinell | Nanokomposit | 280-350nm | 450-750nm |
| (Ca,Sr)AlO₄:Eu,Dy | Spinell | Mikrokristallin | 300-500nm | 450-540nm |
| GdVO₄:Eu³⁺,Sm⁺³, Bi⁺³ | Spinell | Mikrokristallin | 350-450nm | 500-650nm |
| YVO₄:Bi⁺³ | Spinell | Mikrokristallin | 280-400nm | 520-620nm |
| YAG:Ce | Granat | Mikrokristallin | 300-450nm | 520-680nm |
| ZnS/ZnSe, CdSe/ZnSe, CdS/ZnS | Halbleiter-Nanopartikel | Quantum Dots, Nanopartikel, Nanowires | 250-380nm | 400-700nm |
| GaP/InP/ZnP | Halbleiter-Nanopartikel | Quantum Dots, Nanopartikel, Nanowires | 380-550nm | 500-1000nm |

**Tabelle 2: Diverse optisch transparente Feststoffe, die als Matrix zur gleichmässigen Verteilung von farbverschiebenden Verbindungen dienen können, und typische Anwendung bzw. Arten der Inkorporation von Pigmenten und Phosphoren (Farbverschieber/Matrix Paare):**

| **Matrixmaterial** | **Stoffklasse:** | **Morphologie** | **Kompatibel mit Phosphorklasse:** |
|---|---|---|---|
| Quarz | SiO₂ | Kristallin | Spinell, Granat, Halbleiter |
| Natronkalkglas | SiO₂ | Glasartig | Spinell, Granat, Halbleiter |
| Saphir | Al₂O₃ | Kristallin | Spinell, Granat, Halbleiter |
| Aluminosilikat | Al₂O₃/SiO₂ | Glasartig | Spinell, Granat, Halbleiter |
| SiO₂/Zn₂SiO₄ | SiO₂ | Nanokomposit | Spinell, Granat, Halbleiter, Quantum Dots |
| Silica-aerogel | SiO₂ | Aerogel | Alle |
| Silica/Alumina-Aerogel | SiO₂/Al₂O₃ | Aerogel | Alle |
| Silica/Titania-Aerogel | SiO₂/TiO₂ | Aerogel | Alle |
| Organisch verknüpftes SiO₂ Aerogel (X-Aerogel) | Hybridaerogel SiO₂/ organisch | Aerogel | Alle |
| Polysiloxan | Si-C polymer | Polymer (amorph) | Alle |
| Poly-methyl-methacrylat PMMA (Acryl- / Plexiglas) | Acrylat | Polymer (amorph) | Alle |
| Polystyrol (PS) | Vinyl | Polymer (amorph / kristallin) | Halbleiter, Quantum Dots, Organisch |
| Poly-Divinyl-benzol (PDVB) | Vinyl | Polymer (amorph) | Halbleiter, Quantum Dots, Organisch |
| Polycarbonat | Ester | Polymer (amorph) | Alle |
| Poly-ethylen-terephtalat (PET) | Ester | Polymer (amorph / kristallin) | Alle |

**Tabelle 3: Aerogel Diffusor Materialien und deren Eigenschaften:**

| **Chemische Zusammensetzung [Haupt** / **Nebenkomponente]** | **Porosität** [%] | **Dichte [g cm⁻³]** | **Farbverschiebend** |
|---|---|---|---|
| SiO₂ | 92 | 0.11 | Nein |
| SiO₂ | 88 | 0.14 | Nein |
| SiO₂/ Spinell - Pigmente | 85 | 0.17 | Ja |
| SiO₂/ZnO Nanopartikel | 88 | 0.14 | Ja |
| SiO₂/Al₂O₃ | 86 | 0.21 | Nein |
| Al₂O₃/SiO₂ | 80 | 0.31 | Nein |
| SiO₂/TiO₂/YAG:Ce | 87 | 0.22 | Ja |
| SiO₂/(Polystyrol / Coumarin Pigmente) | 88 | 0.17 | Ja |
| SiO₂/(Poly-divinylbenzolstyrol / Perylen Pigmente) | 97 | 0.13 | Ja |
| SiO₂/diisocyanate (X-aerogel) | 81 | 0.17 | Nein |
| SiO₂/CeO₂ | 82 | 0.33 | Nein |
| SiO₂/Polyanthrachinon | 82 | 0.18 | Ja |

In erfindungsgemässer Weise können Aeorgelmaterialien beliebig mit anderen Materialien (Glaskörner, Milchglas, Fasern etc.) kombiniert werden, unter der Bedingung, dass der Volumenanteil an Aerogel in der Mischung (ausgenommen des Luftanteils im Falle von Granulatschüttgut) 60% nicht unterschreitet.

In Sinne der Erfindung können auch jegliche farbverschiebende Materialien als Pigmente, gefärbte Gläser, Kunststoffplatten oder beschichtete Körper etc. beliebig mit Aerogelmaterialien zu optischen Elementen vereint werden.

### Beispiele

Die nachfolgenden Beispiele zeigen exemplarische Ausführungsformen der Erfindung und sind nicht als Beschränkung der in den Ansprüchen definierten Gegenstands zu verstehen. Insbesondere können die in den Beispielen beschriebenen, erfindungsgemäss einzusetzenden Komponenten je nach Einsatzbereich auch miteinander kombiniert oder untereinander substituiert werden.

### Beispiel 1: Paneel-artiges optisches Element mit Aerogel-Granulat Füllung, mit 3-Komponenten Farbverschiebung (blaugrün-orange-rot) nur im Aerogel

Ein nicht-phosphoreszierendes Aerogelmaterial sowie drei verschiedenfarbig phosphoreszierende Aerogelmaterialien (Aerogel-Posphors) werden separat je durch einen Sol-Gel Prozess und anschliessende Trocknung hergestellt.

### Non-Phosphor Siliziumoxid (silica) Aerogel

200g Wasserglas (Natriumorthosilikatlösung Na₄SiO₄, 39% nach Gewicht) werden in 2000g Wasser verdünnt und mit 20ml verdünnter Oxalsäure versetzt. Die Reaktionslösung wird während einer Stunde bei 50°C gerührt. Danach wird der Rührprozess gestoppt, und innerhalb einer weiteren Stunde geliert das Reaktionsgemisch. Das Gel wird während 12h gealtert und mechanisch in kleine Stücke zerteilt. Danach wird das Gel-Granulat erst mit Ethanol und dann mit Hexan gewaschen und anschliessend mit einer verdünnten MTCS (Methyltrichlorsilan) Lösung während 6 Stunden hydrophobiert. Die überschüssige Lösung wird nun abdekantiert und das Gelmaterial in einem Trockenschrank bei 60°C und später bei 150C getrocknet. Bessere optische Eigenschaften werden erreicht, indem das Gelmaterial durch superkritische CO₂ Extraktion getrocknet wird. Das fertige Aerogelgranulat wird anschliessend durch einen Siebprozess nach Partikelgrössen aufgetrennt. Es weist eine tyische Porosität von 91 % und eine Dichte von 0.14 g cm⁻³ auf.

### Blaugrüner Aerogel-Phosphor

270g Tetraethoxysilan (TEOS) werden in 650g einer Alkohollösung gelöst und mit 4ml verdünnter Trichloressigsäure versetzt. Nachdem die Hydrolysereaktion abgeschlossen ist, werden 4ml einer blau-grünen Pigmentlösung zugegeben. Diese besteht aus Polystyrol-Mikrokügelchen mit einem Durchmesser von 1 bis 5µm, suspendiert in Wasser, welche mit einem kommerziellen, blaugrünen lumineszierenden Perylen-Farbstoff, wie etwa Lumogen F grün 850 von BASF dotiert sind. Das Sol wird nun gut vermischt, und unter stetigem Rühren werden 2ml verdünnte Ammoniaklösung zugegeben. Nach beendeter Zugabe wird der Rührprozess gestoppt, und innerhalb von 30 Minuten geliert das Reaktionsgemisch. Dieses wird nun gealtert und mechanisch in kleine Stücke zerteilt. Danach wird das Gel-Granulat erst mit Ethanol und dann mit Hexan gewaschen und anschliessend mit einer verdünnten MTCS (Methyltrichlorsilan) Lösung während 6 Stunden hydrophobiert. Die überschüssige Lösung wird nun abdekantiert und das Gelmaterial in einem Trockenschrank bei 60°C und später bei 120°C getrocknet. Der fertige, blaugrüne Aerogel-Phosphor wird am Ende durch einen Siebprozess ebenfalls nach Partikelgrössen aufgetrennt.

### Orangefarbener Aerogel-Phosphor

In analoger Weise zur oben beschriebenen Herstellung eines blaugrünen Aerogel-Phospors wird ein orangefarbener Aerogel-Phosphor hergestellt, ausser dass anstelle von 4ml einer blaugrünen Pigmentlösung hier 4ml einer orangefarbenen Pigmentlösung zugegeben werden. Letztere besteht wiederum aus Polystyrol-Mikrokügelchen mit einem Durchmesser von 1 bis 5µm, suspendiert in Wasser, welche mit einem kommerziellen, orange lumineszierenden Perylen-Farbstoff, wie etwa Lumogen F orange 240 von BASF, dotiert sind.

### Roter Aerogel-Phosphor

Ebenfalls in analoger Weise zur oben beschriebenen Herstellung eines blaugrünen Aerogel-Phospors wird ein roter Aerogel-Phosphor hergestellt, ausser dass anstelle von 4ml einer blaugrünen Pigmentlösung 4ml einer roten Pigmentlösung zugegeben werden. Letztere besteht wiederum aus Polystyrol-Mikrokügelchen mit einem Durchmesser von 1 bis 5µm, suspendiert in Wasser, welche mit einem kommerziellen, orange lumineszierenden Perylen-Farbstoff, wie etwa Lumogen F rot 300 von BASF, dotiert sind.

### Herstellung des optischen Elements

Zur Herstellung eines optischen Elements wird ein beidseitig offenes Hohlkörperprofil aus transparentem d.h. nicht mit Lumineszenzmittel versehenem Polycarbonat mit den Abmessungen 63cm * 12cm * 1.8cm und einer Wandstärke von 1.0mm verwendet. Auf der einen offenen Seite wird nun ein passendes Aluminiumprofil bündig eingesetzt und verklebt. Nun wird eine Schüttung aus Aerogelgranulatkörnern gemäss untenstehender Tabelle 4 hergestellt und durch Durchmischung homogenisiert.

**Tabelle 4:**

| **Material:** | **Volumenanteil:** | **Korngrösse:** |
|---|---|---|
| Transluzentes (non-Phoshpor) Aerogel Granulat | 80% | 3.5mm +/- 0.5mm |
| Blaugrüner Aerogel-Phospor | 15% | 2.0mm +/- 0.5mm |
| Orangefarbener Aerogel-Phospor | 3% | 2.0mm +/- 0.5mm |
| Roter Aerogel-Phospor | 2% | 2.0mm +/- 0.5mm |

Der Hohlkörper wird nun mit der eigens präparierten Mischung (Schüttung) von Aerogelmaterialien befüllt. Wichtig ist, dass während des Füllvorgangs der Körper mit der verklebten Seite nach unten stetig geklopft wird, sodass das Aerogel Material sich setzen kann und eine möglicht dichte Packung resultiert. Nun wird der dicht mit der Aerogel-Schüttung gepackte Körper mit einem zweiten, identischen Aluminiumprofil ebenfalls verklebt und ist somit hermetisch verschlossen.

Das so hergestellte optische Element kann durch eine gleichmässige flächenartige Anordnung von 4 x 24 kommerziellen, kaltweissen (5500-7000 K) 3W Hochleistungs-LED von der Hinterseite beleuchtet werden, wobei das farbverschobene Licht gleichmässig an die Umgebung abgegeben wird.

### Beispiel 2: Paneel-artiges optisches Element mit Aerogel-Granulat Füllung, mit aus unterschiedlichen Komponenten aufgebauter 3-Farben Verrschiebung (blaugrün-orange-rot) nur im Aerogel

Im Unterschied zum obigen Beispiel 1 wurde bei der Herstellung der lumineszierenden Aerogelmaterialien eine Auswahl von drei unterschiedlichen Substanzklassen zur Farbverschiebung verwendet.
- Als grüner Phosphor wurde ein mit Kupferionen dotiertes Zinksulfid (ZnS:Cu) verwendet. Dieses kann durch UV-Licht, beispielsweise aus einer entsprechenden weiteren Lichtquelle, zusätzlich (selektiv) stimuliert werden.
- Als orangefarbener Phosphor wird eine Cer dotierte YAG Granatverbindung eingesetzt (YAG:Ce).
- Als Roter Phgosphor werden Indiumphosphid (InP) Nanopartikel mit einer mittleren Teilchengrösse von ungefähr 8nm verwendet.

Alle Phosphorkomponenten werden in identischer Weise wie in Beispiel 1 erwähnt, d.h. in Polystyrol-Mikrokügelchen eingeschlossen bzw. verkapselt, in das entsprechende Aerogelmaterial inkorporiert.

### Beispiel 3: Paneel-artiges optisches Element mit optisch neutralerAerogel-Granulat Füllung sowie 2-Farben Verschiebung (blaugrün und orange-rot) dem Granulat beigemischte, lumineszente Partikel und Fasern

Im Unterschied zu Beispiel 1 findet die Farbverschiebung nicht im Aerogel selbst statt sondern in zwei dem Granulat zugegebenen Nebenkomponenten.
- Als grüner Farbverschieber werden dem Granulat Glasfasern zugegeben, welche mit der Spinel Verbindung (Ca,Sr)AlO₄:Eu beschickt sind
- Als im orange-roten Spektralbereich wirksamer Farbverschieber werden Coumarin 6 enthaltende Polyethylenterephtalat (PET) Kügelchen mit einem Nominaldurchmesser von 1.0 +/- 0.2mm eingesetzt.

### Beispiel 4: Paneel-artiges optisches Element mit Aerogel-Granulat Füllung und Farbverschiebung nur in der Umrandung

Im Unterschied zum Beispiel 1 wurde ein Hohlkörperprofil aus einem grün phosporeszierendem Poly-methylmethacrylat (Acrylglas, Plexiglas) verwendet. Dieses Material wird durch Erhitzen des Kunststoffs über den Erweichungspunkt T_{G} sowie Beimischen von ungefähr 3.0 Gewichtsprozent des organischen Lumineszenzmittels Lumogen F grün 850 von BASF erhalten. Nach dem Abkühlen erstarrt der eingefärbte Kunststoff wieder und kann nach Belieben weiterverarbeitet werden. Der Hohlkörper ist ausschliesslich mit dem transluzenten (non-Phosphor) Aerogel Granulat befüllt, d.h. in diesem Fall findet die Farbverschiebung vollumfänglich in der Hülle statt.

### Beispiel 5: Optisches Element in einer Paneel-artigen Ausführung, mit Farbverschiebung teils im Aerogel (gelb-rot) und teils in der Umrandung (grün)

Im Unterschied zum obigen Beispiel 4 wurde ein Hohlkörperprofil aus einem grün lumineszierenden Polycarbonat, welches in ähnlicher Weise wie das oben erwähnte grüne Acrylglas eingefärbt wurde, verwendet. Das Profil ist mit einer Mischung aus dem transluzenten (non-Phosphor), dem orangefarbenen und dem roten Aerogel Granulat gemäss Zusammensetzung in der untenstehenden Tabelle 5 befüllt, welches zuvor durch einen Mischprozess homogenisiert wurde.

**Tabelle 5:**

| **Material:** | **Volumenanteil:** | **Korngrösse:** |
|---|---|---|
| Transluzentes (non-Phoshpor) Aerogel Granulat | 80% | 3.5mm +/- 0.5mm |
| Orangefarbener Aerogel-Phospor | 3% | 2.0mm +/- 0.5mm |
| Roter Aerogel-Phospor | 2% | 2.0mm +/- 0.5mm |

In diesem Beispiel handelt es sich also um eine Kombination von Farbverschiebung im Paneel sowie im Aerogeldiffusormaterial selbst. Zudem kann durch Zuschalten weiterer LEDs das Farbspektrum des an die Umgebung abgegebenen Lichts aktiv verändert werden.

### Beispiel 6: Paneel-artige optische Komponente aus einem monolithischen Aerogel-Körper ohne Farbverschiebung

250g Tetramethoxysilan (TMOS) werden in 1000ml einer wässrigen Methanollösung gerührt. Dann werden 50 ml einer Propionsäurelösung langsam zugetropft. Das Gemisch wird während 12 Stunden bei 40°C gerührt und unter heftigem Rühren werden schliesslich 20ml verdünnte Ammoniaklösung zugegeben. Nun wird das Gemisch sofort in eine Form nach Wahl gegossen, welches die Gestalt des monolythischen Körpers am Ende bestimmt. Nachdem die Gelierung stattgefunden hat, wird dieses Während 50h gealtert. Dann wird es mit Methanol gewaschen und mit einer verdünnten HMDS (Hexamethyldisilazan) Lösung während 20h bei 30°C hydrophobiert. Das Lösungsmittel wird erneut ausgetauscht und der monolithische Körper in einer Autoklave mittels überkritischem CO₂ getrocknet.

### Beispiel 7: Beleuchtungselement mit einer Paneel-artigen optischen Komponenten aus einem monolithischen Aerogel-Körper mit Farbverschiebung durch eine orangefarben lumineszierende Schicht auf dem Aerogel

Ein monolithischer Aerogelkörper gemäss dem obigen Beispiel 6 wird nach der Trocknung mit einer verdünnten Polyantrachinonlösung besprüht. Das Lösemittel verdampft von selbst und zurück bleibt eine orangefarben luzmineszierende Oberflächenbeschichtung auf dem Aerogelkörper.

### Beispiel 8: Beleuchtungselement mit einer Skluptur-artigen optischen Komponenten aus einem monolithischen Aerogel-Körper mit Farbverschiebung durch Oberflächenschicht (orangefarben) sowie im Aerogelmaterial selbst (grün), welches durch Lichtleiter beleuchtet wird

Im Unterschied zum Beispiel 6 wird vor der Zugabe der Ammoniaklösung, d.h. vor dem Einleiten des Gelierungsschrittes, ein Farbkonverter in Form einer Suspension von ZnS/ZnSe core-shell Quantum dots (Nanopartikeln) zugegeben. Die Form entspricht der Negativ-Passform für die zu replizierende Skulptur. Darin wird vor dem Eingiessen des mit Ammoniak versehenen Solgemisches eine Auswahl an Lichtleiterkabeln platziert. Nach dem Trocknungsschritt wird die fertige Skulptur in gleicher Weise wie in Beispiel 7 beschrieben mit der lumineszierenden Schicht aus Polyanthrachinon beaufschlagt.

Durch die Lichtleiterkabel kann das Licht einer oder mehrerer LED Quellen direkt in die Aerogelskulptur eingebracht werden.

## Patentansprüche

1. Optisches Element, insbesondere zur Veränderung des von einer LED-Lichtquelle (L) emittierten Lichts, umfassend einen Lichtdiffusor (D) sowie einen Farbkonverter (F), **dadurch gekennzeichnet, dass** der Lichtdiffusor (D) zu mindestens 60% Volumenanteil aus einem Aerogelmaterial mit einer Porosität von mindestens 85% gebildet ist und der Farbkonverter (F; F1; F2) aus mindestens einem Lumineszenzmittel gebildet ist, wobei das Aerogelmaterial mit dem Lumineszenzmittel durchsetzt und/oder von diesem im Wesentlichen vollständig umschlossen ist.

2. Optisches Element nach Anspruch 1, wobei der Lichtdiffusor (D) monolithisch ausgebildet ist und wobei zumindest eine Mantelfläche des Lichtdiffusors mit dem Lumineszenzmittel (F; F2) belegt ist.

3. Optisches Element nach Anspruch 1, wobei der Lichtdiffusor (D) monolithisch ausgebildet und mit dem Lumineszenzmittel (F; F1) durchsetzt ist.

4. Optisches Element nach Anspruch 3, wobei zumindest eine Mantelfläche des Lichtdiffusors (D) mit einem weiteren Lumineszenzmittel (F2) belegt ist.

5. Optisches Element nach Anspruch 1, wobei der Lichtdiffusor (D) durch ein Granulat (G) gebildet ist, das in einem lichtdurchlässigen Behältnis (B) vorliegt, das mit dem Lumineszenzmittel (F; F2) belegt oder von diesem durchsetzt ist.

6. Optisches Element nach Anspruch 1, wobei der Lichtdiffusor (D) durch ein Granulat (G) gebildet ist, wobei mindestens ein Teil des Granulats mit dem Lumineszenzmittel (F; F1) durchsetzt oder von diesem belegt ist.

7. Optisches Element nach Anspruch 6, wobei das lichtdurchlässige Behältnis (B) mit einem weiteren Lumineszenzmittel (F2) belegt oder von diesem durchsetzt ist.

8. Optisches Element nach Anspruch 6 oder 7, wobei mindestens ein weiterer Teil des Granulats (G) mit noch einem weiteren Lumineszenzmittel (F1) durchsetzt oder von diesem belegt ist.

9. Optisches Element nach einem der Ansprüche 1 bis 8, wobei der Lichtdiffusor (D) mit mindestens einem Lichtleiter (FO) zum Einspeisen von Licht ausgestattet ist.

10. Optisches Element nach einem der Ansprüche 1 bis 9, wobei das Lumineszenzmittel mindestens eine Verbindung der Klasse der organischen Phosphore, der Quantum Dots, der Familien der III-V, II-VI und I-VII Halbleiterpaare oder der Granate (garnets) oder ein lumineszierendes Polymer enthält.

11. Optisches Element nach einem der Ansprüche 1 bis 10, wobei das Aerogelmaterial als Hauptkomponente eine aus Siliziumoxid, Titanoxid, Aluminiumoxid, Zirkonoxid, Eisenoxid, Chromoxid, Vanadiumoxid, Ceroxid und Nioboxid ausgewählte Verbindung enthält.

12. Optisches Element nach einem der Ansprüche 1 bis 11, wobei das Aerogelmaterial eine Dichte aufweist, die ungefähr 1 % bis ungefähr 20% der gemittelten Dichte seiner Bestandteile beträgt.

13. Optisches Element nach einem der Ansprüche 1 bis 12, wobei der Farbkonverter zusätzlich zum Lumineszenzmittel ein Aerogel oder ein mesoporöses Metalloxid oder ein Xerogel als volumenmässige Hauptkomponente umfasst.

14. Optisches Element nach einem der Ansprüche 1 bis 13, wobei der Farbkonverter zusätzlich zum Lumineszenzmittel ein anorganisches oxidisches Material, ein Glas oder ein Polymer als volumenmässige Hauptkomponente umfasst.

15. Verfahren zur Herstellung eines optischen Elementes nach Anspruch 1, **dadurch gekennzeichnet, dass** das Aerogelmaterial des optischen Diffusors durch einen Sol-Gel-Prozess hergestellt wird.
